# FASCICULE DE BREVET EUROPEEN

(11) **EP 2 045 923 B1**
(45) Date de publication et mention de la délivrance du brevet: **15.09.2010**
(21) Numéro de dépôt: 08164996.4
(22) Date de dépôt: 24.09.2008
(51) Int. Cl.: H03K 17/96

(54) **Dispositif à touche sensitive par effet capacitif éclairé et clavier de commande comprenant un tel dispositif**
Vorrichtung mit beleuchteter, auf dem kapazitiven Effekt beruhenden berührungsempfindlichen Taste und Steuertastatur, die eine solche Vorrichtung umfasst
Device with lit capacitive touch switch and control keypad comprising such a device

(30) Priorité: 27.09.2007 FR 0706803
(43) Date de publication de la demande: 08.04.2009
(73) Titulaire: FagorBrandt SAS, 92500 Rueil Malmaison (FR)
(72) Inventeur: Geoffroy, Philippe, 45370 Cléry Saint André (FR); Oudart, Pascal, 45240 La Ferté Saint Aubin (FR)

(56) Documents cités:
- EP-A- 1 257 057
- WO-A-2004/107062
- US-A- 5 239 152

## Description

La présente invention concerne un dispositif de touche sensitive par effet capacitif, ainsi qu'un clavier de commande intégrant un tel dispositif. Ce dispositif de touche sensitive permet l'éclairage de ladite touche sensitive.

Les dispositifs à touche sensitive sont utilisés notamment dans les claviers numériques, pour des appareils électriques domestiques, et par exemple une table de cuisson, un four de cuisson ou une hotte, ou encore un lave-linge, un sèche-linge ou un lave-vaisselle.

De tels dispositifs permettent de détecter la présence d'un élément tel qu'un doigt d'un utilisateur à travers un corps électriquement isolant. Le corps électriquement isolant peut être une plaque de verre, de vitrocéramique ou de plastique constituant un bandeau de commande d'un appareil électrique.

En pratique, le fait de placer un doigt dans une zone au regard d'une touche sensitive a pour effet d'engendrer une variation de capacité dépendante notamment de la surface du doigt en vis-à-vis d'une surface de détection de la touche sensitive.

En reliant électriquement la touche sensitive à un circuit électronique, il est possible de détecter la variation du courant haute fréquence circulant dans le circuit ainsi constitué par la touche sensitive, le doigt de l'utilisateur et le corps de l'utilisateur relié à la terre.

La zone d'appui de la touche sensitive est identifiée par une sérigraphie réalisée sur une surface du corps électriquement isolant.

Cependant, ces dispositifs de touche sensitive ont l'inconvénient de ne pas permettre de connaître l'état de la touche sensitive. L'utilisateur ne peut savoir en regardant l'interface de commande d'un appareil électrique si la touche est activée ou désactivée.

Le document WO 2004/107062 A1 présente un dispositif de touche sensitive illuminé.

On connaît également un document EP1376872 qui décrit un dispositif d'éclairage d'un bouton de commande prévu sur une vitre transparente. Ce dispositif d'éclairage comprend une source lumineuse, un conducteur de lumière et un commutateur sensitif monté derrière le bouton de commande. La source lumineuse est disposée à distance du bouton de commande et rayonne dans le conducteur de lumière disposé sous la vitre. La lumière est conduite dans le guide de lumière en direction du bouton de commande. Et la lumière est conduite à l'intérieur d'une zone entre le capteur du commutateur sensitif et le bouton de commande. Ce document prévoit l'assemblage du conducteur de lumière par collage sur la vitre et/ou sur le circuit imprimé portant la source lumineuse.

Cependant, ce dispositif d'éclairage d'un bouton de commande présente l'inconvénient d'utiliser un moyen de fixation par collage pour relier le conducteur de lumière à la vitre et/ou au circuit imprimé.

Or, la liaison par collage provoque des perturbations de fonctionnement du commutateur sensitif ne détectant pas de manière sûre et permanente le doigt de l'utilisateur lors de l'utilisation du bouton de commande. Ces perturbations de fonctionnement du commutateur sensitif sont notamment dues aux bulles d'air se logeant à l'intérieur de la bande adhésive transparente déposée sur le conducteur de lumière.

En outre, ce dispositif d'éclairage d'un bouton de commande impose un positionnement du guide de lumière fixe par rapport à la vitre ou au circuit imprimé et empêchant tout ajustement du guide de lumière en vis-à-vis du bouton de commande. Ce dispositif d'éclairage ne permet pas de prendre en considération les déformations du circuit imprimé et de la vitre pour positionner le guide de lumière en vis-à-vis de la source lumineuse.

Par ailleurs, la fixation par collage du conducteur de lumière sur le circuit imprimé ou la vitre ne permet pas au commutateur sensitif d'ajuster le positionnement dudit conducteur de lumière sur ladite vitre.

La fixation par collage du conducteur de lumière sur le circuit imprimé ou la vitre ne permet également pas de garantir un contact permanent entre la vitre, le conducteur de lumière et le commutateur sensitif de sorte à obtenir un fonctionnement sans perturbations du bouton de commande.

Un tel dispositif d'éclairage ne permet pas de s'affranchir de diélectriques pouvant être générés entre la vitre, le conducteur de lumière et le commutateur sensitif par une lame d'air provoquant des perturbations de fonctionnement du bouton de commande.

La présente invention a pour but de résoudre les inconvénients précités et de proposer un dispositif à touche sensitive permettant de visualiser l'état de fonctionnement de la touche sensitive.

A cet effet, la présente invention vise un dispositif à touche sensitive par effet capacitif pour détecter la présence d'un élément à travers une plaque électriquement isolante, la touche sensitive comportant une face de détection pleine destinée à être plaquée contre une surface inférieure d'un guide de lumière, ladite face de détection de ladite touche sensitive étant opaque à la lumière, et ladite touche sensitive étant portée par une plaquette de circuit imprimé, le guide de lumière comportant une surface pleine de diffusion de la lumière destinée à être plaquée contre une surface intérieure de la plaque électriquement isolante.

Selon l'invention, le dispositif à touche sensitive comprend :
- au moins une source lumineuse assemblée sur la plaquette de circuit imprimé et placée en vis-à-vis d'au moins un premier élément de diffusion du guide de lumière ;
- ledit au moins un premier élément de diffusion du guide de lumière étant relié à un second élément de diffusion du guide de lumière ;
- ledit second élément de diffusion du guide de lumière comprenant la surface inférieure et la surface pleine de diffusion de la lumière dudit guide de lumière ;
- ledit second élément de diffusion du guide de lumière étant positionné entre la face de détection de la touche sensitive et la surface inférieure de la plaque électriquement isolante ;
- ladite surface pleine de diffusion de la lumière étant plaquée contre la surface intérieure de la plaque électriquement isolante par une partie intermédiaire élastique de la touche sensitive ;
- au moins une partie transparente ou translucide de la plaque électriquement isolante étant réalisée en vis-à-vis de la face de détection opaque de ladite touche sensitive pour permettre le passage de la lumière émise par ladite au moins une source lumineuse et diffusée au travers du guide de lumière ;
- au moins un icône représenté sur la plaque électriquement isolante étant réalisé sur au moins une partie de la zone définie par la projection de la face de détection opaque de ladite touche sensitive sur ladite plaque électriquement isolante ; et
- la surface pleine de diffusion de la lumière du guide de lumière recouvrant au moins la surface dudit au moins un icône représenté sur la plaque électriquement isolante.

Ainsi, le dispositif à touche sensitive permet d'éclairer un icône d'une touche sensitive comprenant une face de détection pleine et opaque à la lumière sans réaliser une ouverture pour le passage de la lumière dans ladite face de détection.

Les touches sensitives sont toutes identiques pour l'ensemble des fonctions pouvant être associées à celles-ci. Le coût d'obtention des touches sensitives est minimisé et permet d'avoir une seule référence.

La source lumineuse permet d'éclairer au moins une partie transparente ou translucide de la plaque électriquement isolante par l'intermédiaire du guide de lumière et d'afficher un icône disposé en regard de la face de détection de la touche sensitive. L'icône représente une fonction de commande par le passage de la lumière au travers de ladite au moins une partie transparente ou translucide de la plaque électriquement isolante.

Le positionnement du guide de lumière en contact avec la plaque électriquement isolante par la partie intermédiaire élastique de la touche sensitive permet d'éviter la création de diélectriques sous forme de lame d'air entre la plaque électriquement isolante, le guide de lumière et la face de détection de la touche sensitive.

Ainsi, la touche sensitive détecte de manière sûre et fiable un élément placé en vis-à-vis de la face de détection de la touche sensitive au travers de la plaque électriquement isolante.

La mise en contact de la plaque électriquement isolante, du guide de lumière et de la touche sensitive est garantie par l'élasticité de la partie intermédiaire de ladite touche sensitive.

Le contact de la plaque électriquement isolante, du guide de lumière et de la touche sensitive est assuré par des appuis des surfaces les unes aux autres sans avoir recours à un moyen de fixation.

Seule l'élasticité de la partie intermédiaire de la touche sensitive permet de comprimer la face de détection de la touche sensitive sur le guide de lumière et ledit guide de lumière sur la plaque électriquement isolante.

Par ailleurs, l'icône représenté sur la plaque électriquement isolante est placé en vis-à-vis de la face de détection de la touche sensitive et permet ainsi d'éviter de rechercher la zone de détection de la touche sensitive.

En outre, le positionnement de la source lumineuse en vis-à-vis d'un premier élément de diffusion guide de lumière permet d'éviter de visualiser un point lumineux au travers de la plaque électriquement isolante. Le premier élément de diffusion diffuse la lumière de la source lumineuse montée sur la plaquette de circuit imprimé dans le guide de lumière.

La surface inférieure du second élément de diffusion du guide de lumière est posée sur la face de détection de la touche sensitive.

Ainsi, le guide de lumière est supporté par la touche sensitive et repoussé par la partie intermédiaire élastique de ladite touche sensitive.

Selon une caractéristique préférée de l'invention, le guide de lumière comporte deux premiers éléments de diffusion de lumière s'étendant entre la plaquette de circuit imprimé et la plaque électriquement isolante, lesdits deux premiers éléments de diffusion de lumière étant reliés respectivement à une extrémité du second élément de diffusion du guide de lumière, et lesdits deux premiers éléments de diffusion de lumière étant positionnés respectivement en vis-à-vis d'une source lumineuse.

Ainsi, la lumière est diffusée au travers de deux premiers éléments de diffusion reliés respectivement à un deuxième élément de diffusion du guide de lumière afin d'afficher l'icône représenté sur la plaque électriquement isolante. La lumière diffusée par les deux sources lumineuses au travers des éléments de diffusion du guide de lumière est uniforme. Un tel agencement des éléments de diffusion du guide de lumière dans le dispositif à touche sensitive permet d'éviter des déperditions de lumière et de garantir un niveau de luminosité déterminé par l'intensité des sources lumineuses.

Selon une autre caractéristique préférée de l'invention, la touche sensitive et le guide de lumière sont placés à l'intérieur d'un logement d'un boîtier, ledit boîtier s'étendant de la plaquette de circuit imprimé à la surface inférieure de la plaque électriquement isolante.

Ainsi, la lumière diffusée par le guide de lumière est canalisée à l'intérieur d'un logement d'un boîtier pour un dispositif à touche sensitive sans éclairer un autre dispositif à touche sensitive pouvant être situé à proximité ou sans laisser un passage de lumière en direction d'une partie transparente ou translucide de la plaque électrique isolante n'appartenant pas audit dispositif.

En pratique, ledit au moins un premier élément de diffusion du guide de lumière comprend une nervure coulissant à l'intérieur d'une rainure formée sur une paroi du logement du boîtier.

Ainsi, le guide de lumière est positionné à l'intérieur du logement du boîtier et le déplacement de celui-ci est maîtrisé. La partie intermédiaire élastique de la touche sensitive permet ainsi de déplacer le guide de lumière à l'intérieur du logement du boîtier selon une direction prédéterminée. Le déplacement du guide de lumière est guidé et permet d'assurer que le contact entre le guide de lumière et la plaque électriquement isolante est réalisé sur la totalité de la surface pleine de diffusion de lumière du guide de lumière.

D'autres particularités et avantages de l'invention apparaîtront encore dans la description ci-après.

Aux dessins annexés, donnés à titre d'exemples non limitatifs :
- la figure 1 est un vue éclatée illustrant un clavier de commande comprenant une pluralité de dispositifs à touche sensitive conforme à l'invention ;
- la figure 2 est une vue en perspective d'un clavier de commande comprenant une pluralité de dispositifs à touche sensitive conforme à l'invention ;
- la figure 3 est une vue en coupe illustrant un mode de réalisation du dispositif à touche sensitive sans la plaque électriquement isolante ;
- la figure 4 est une seconde vue en coupe, selon une direction perpendiculaire à la figure 3, illustrant un mode de réalisation du dispositif à touche sensitive sans la plaque électriquement isolante ;
- la figure 5 est une vue en coupe illustrant un mode de réalisation du dispositif à touche sensitive avec la plaque électriquement isolante ; et
- la figure 6 est une seconde vue en coupe, selon une direction perpendiculaire à la figure 5, illustrant un mode de réalisation du dispositif à touche sensitive avec la plaque électriquement isolante.

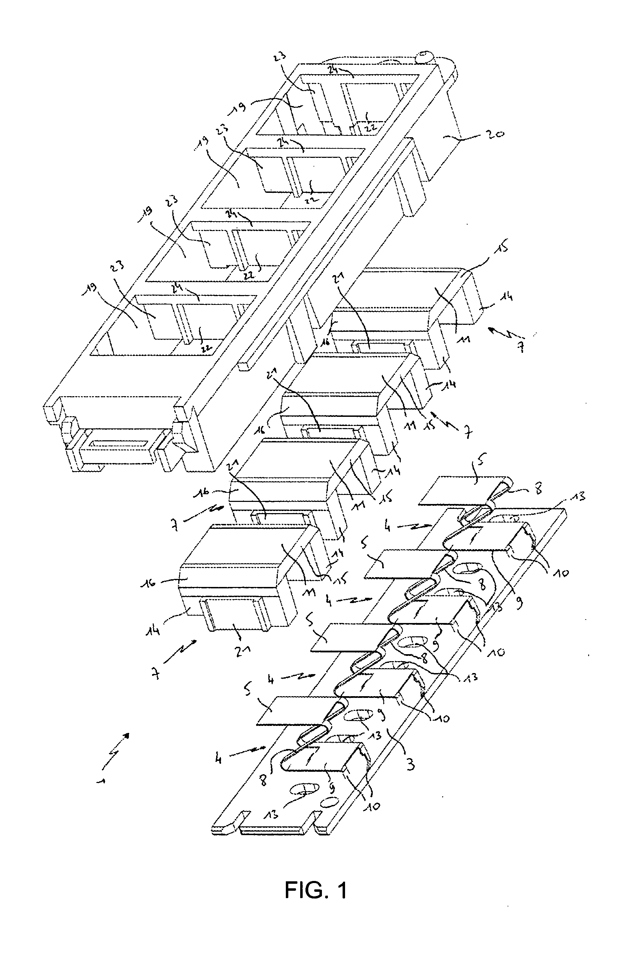

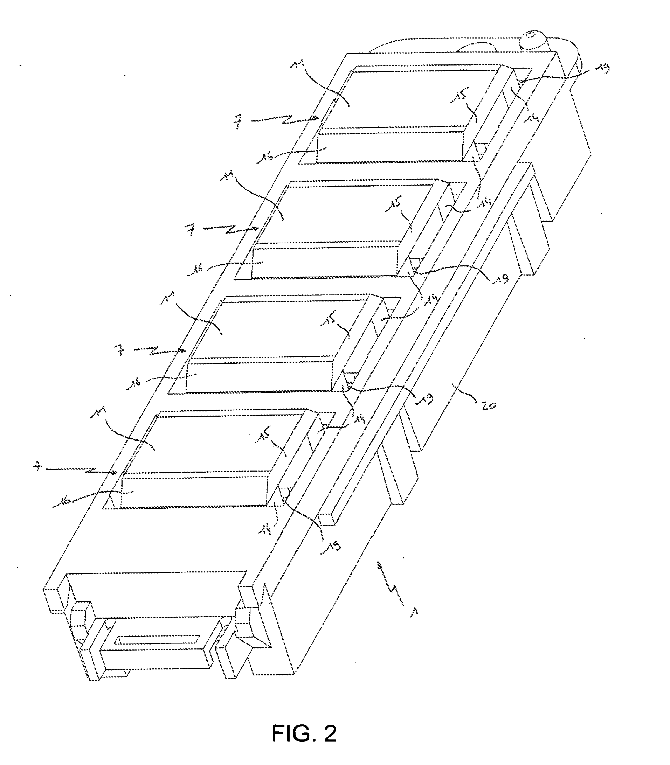

On va décrire tout d'abord en référence aux figures 1 à 6 un dispositif à touche sensitive par effet capacitif conforme à un mode de réalisation de l'invention.

Sur la figure 1, on a illustré schématiquement un clavier de commande comprenant une pluralité de dispositifs à touche sensitive conforme à l'invention dans une vue éclatée permettant de visualiser les moyens nécessaires à la mise en oeuvre de l'invention.

Bien entendu, l'ensemble de ces éléments est intégré de manière compacte dans un boîtier du clavier de commande.

Le dispositif à touche sensitive 1 est adapté à détecter la présence d'un élément, tel que par exemple un doigt d'un utilisateur à travers une plaque électriquement isolante 2.

La plaque électriquement isolante 2 est réalisée dans une matière telle que du verre, de la vitrocéramique ou du plastique.

Cette plaque électriquement isolante 2 constitue un élément de la commande d'un appareil électrique domestique, du type appareil de cuisson, hotte, appareil de lavage, ...

En référence à la figure 1, on a illustré un exemple de réalisation d'une telle touche sensitive de détection montée sur une plaquette de circuit imprimé 3.

La touche sensitive 4 comporte une face de détection 5 pleine destinée à être plaquée contre une surface inférieure 6 d'un guide de lumière 7.

Cette face de détection 5 est destinée à venir en contact avec ladite surface 6 du guide de lumière 7.

Cette face de détection 5 est reliée par une partie intermédiaire 8 à une embase 9 destinée à être fixée par exemple par des plots de connexion 10 à la plaquette de circuit imprimé 3.

La partie intermédiaire 8 présente dans ce mode de réalisation une certaine flexibilité de telle sorte que la face de détection 5 est en appui élastique contre ladite surface 6 du guide de lumière 7 quel que soit le défaut de parallélisme entre la plaque électriquement isolante 2 et la plaquette de circuit imprimé 3.

Par ailleurs, tout type de touche sensitive 4 peut être utilisé dès lors qu'elle présente une face de détection 5 destinée à venir en contact avec une surface inférieure 6 du guide de lumière 7 et que ladite face de détection 5 soit pleine et opaque à la lumière.

De manière classique dans ce type de détection par effet capacitif, la touche sensitive 4 est reliée électriquement à un circuit électronique de détection par exemple porté par la plaquette de circuit imprimé 3.

Préférentiellement, la touche sensitive 4 par effet capacitif est constituée par une lame ressort en forme de Z. L'embase 9 de la lame ressort, sensiblement plane, forme avec la face de détection 5, les deux parties extrêmes du Z, la partie médiane 8 étant constituée par la partie oblique du Z.

L'embase 9 et la face de détection 5 sont sensiblement planes, et la partie oblique 8 est telle qu'elle permet une flexibilité de la touche sensitive 4.

Le circuit électronique de détection (non représenté) comporte notamment un générateur de courant haute fréquence et un moyen de mesure de la variation de ce courant dans le circuit électrique formé au travers de la touche sensitive 4 reliée à la terre lors de la présence d'un doigt de l'utilisateur en regard de cette touche sensitive 4.

Le dispositif à touche sensitive 1 par effet capacitif permet de détecter la présence d'un élément à travers une plaque électriquement isolante 2.

La face de détection 5 de la touche sensitive 4 est opaque à la lumière.

La face de détection 5 est sans ouverture pour le passage de lumière afin de garantir la sensibilité de la touche sensitive 4. Une ouverture dans la face de détection 5 a pour effet de détériorer l'effet capacitif de la touche sensitive 4 et de diminuer l'aisance de commande d'un appareil électrique domestique comprenant un dispositif à touche sensitive 1 par effet capacitif.

La face de détection 5 est réalisée sans perforations ou au moins une ouverture pour le passage de la lumière de manière à standardiser la touche sensitive 4 pour l'ensemble des commandes d'un appareil électrique domestique. La touche sensitive 4 unique est adaptée à être mise en fonctionnement quel que soit la fonction de commande et à être assemblée sur toute plaquette de circuit imprimé 3.

La face de détection 5 n'a pas besoin d'une personnalisation pour permettre le rétro éclairage de la touche sensitive 4.

La touche sensitive 4 est portée par une plaquette de circuit imprimé 3.

Le guide de lumière 7 comporte une surface pleine de diffusion de la lumière 11 destinée à être plaquée contre une surface intérieure 12 de la plaque électriquement isolante2, et généralement contre une surface destinée à être disposée à l'intérieur d'un appareil, non visible ni accessible par l'utilisateur.

Le dispositif à touche sensitive 1 comprend au moins une source lumineuse 13 assemblée sur la plaquette de circuit imprimé 3 et placée en vis-à-vis d'au moins un premier élément de diffusion 14 du guide de lumière 7.

Ledit au moins un premier élément de diffusion 14 du guide de lumière 7 est relié à un second élément de diffusion 15 du guide de lumière 7.

Ledit second élément de diffusion 15 du guide de lumière 7 comprend la surface inférieure 6 et la surface pleine de diffusion de la lumière 11 dudit guide de lumière 7.

Ledit second élément de diffusion 15 du guide de lumière 7 est positionné entre la face de détection 5 de la touche sensitive 4 et la surface inférieure 12 de la plaque électriquement isolante 2.

Ladite surface pleine de diffusion de la lumière 11 est plaquée contre la surface intérieure 12 de la plaque électriquement isolante 2 par une partie intermédiaire élastique 8 de la touche sensitive 4.

La surface de diffusion de la lumière 11 est pleine de sorte à éviter la formation d'une lame d'air entre la plaque électriquement isolante 2 et le guide de lumière 7.

Ainsi, le fonctionnement de la touche sensitive 4 n'est pas perturbé par la formation d'un diélectrique.

Au moins une partie transparente ou translucide (non illustrée) de la plaque électriquement isolante 2 est réalisée en vis-à-vis de la face de détection 5 opaque de la touche sensitive 4 pour permettre le passage de la lumière émise par ladite au moins une source lumineuse 13 et diffusée au travers du guide de lumière 7.

La forme de ladite au moins une partie transparente ou translucide de la plaque électriquement isolante 2 permet de définir la forme de l'éclairage du dispositif à touche sensitive 1.

Au moins un icône (non illustré) représenté sur la plaque électriquement isolante 2 est réalisé sur au moins une partie de la zone définie par la projection de la face de détection 5 opaque de la touche sensitive 4 sur ladite plaque électriquement isolante 2.

La surface pleine de diffusion de la lumière 11 du guide de lumière 7 recouvre au moins la surface dudit au moins un icône représenté sur la plaque électriquement isolante 2.

Ainsi, le dispositif à touche sensitive 1 permet d'éclairer un icône d'une touche sensitive 4 comprenant une face de détection 5 pleine et opaque à la lumière sans réaliser une ouverture pour le passage de la lumière dans ladite face de détection 5.

Les touches sensitives 4 sont toutes identiques pour l'ensemble des fonctions pouvant être associées à celles-ci. Le coût d'obtention des touches sensitives 4 est minimisé et permet d'avoir une seule référence.

La source lumineuse 13 permet d'éclairer au moins une partie transparente ou translucide de la plaque électriquement isolante 2 par l'intermédiaire du guide de lumière 7 et d'afficher un icône disposé en regard de la face de détection 5 de la touche sensitive 4. L'icône représente une fonction de commande par le passage de la lumière au travers de ladite au moins une partie transparente ou translucide de la plaque électriquement isolante 2.

Le positionnement du guide de lumière 7 en contact avec la plaque électriquement isolante 2 par la partie intermédiaire élastique 8 de la touche sensitive 4 permet d'éviter la création de diélectriques sous forme de lame d'air entre la plaque électriquement isolante 2, le guide de lumière 7 et la face de détection 5 de la touche sensitive 4.

Ainsi, la touche sensitive 4 détecte de manière sûre et fiable un élément placé en vis-à-vis de la face de détection 5 de la touche sensitive 4 au travers de la plaque électriquement isolante 2.

La mise en contact de la plaque électriquement isolante 2, du guide de lumière 7 et de la touche sensitive 4 est garantie par l'élasticité de la partie intermédiaire 8 de ladite touche sensitive 4.

Le contact de la plaque électriquement isolante 2, du guide de lumière 7 et de la touche sensitive 4 est assuré par des appuis des surfaces les unes aux autres sans avoir recours à un moyen de fixation.

Seule l'élasticité de la partie intermédiaire 8 de la touche sensitive 4 permet de comprimer la face de détection 5 de la touche sensitive 4 sur le guide de lumière 7 et ledit guide de lumière 7 sur la plaque électriquement isolante 2.

En outre, l'élasticité de la lame ressort de la touche sensitive 4 repliée en forme de Z est ajustée afin qu'elle applique un effort suffisant sur la surface inférieure 6 du guide de lumière 7 de sorte à plaquer la surface de diffusion de la lumière 11 contre la plaque électrique isolante 2.

Toutefois, l'élasticité de la lame ressort de la touche sensitive 4 repliée en forme de Z est ajustée afin qu'elle n'applique pas un effort trop important sur le guide de lumière 7 et sur la plaquette de circuit imprimé 3.

L'évidement central de la touche sensitive 4 permet lors de la compression de cette dernière de maintenir la face de détection 5 plane grâce à une rigidité supérieure à celle de la partie intermédiaire 8.

Par ailleurs, l'icône représenté sur la plaque électriquement isolante 2 est placé en vis-à-vis de la face de détection 5 de la touche sensitive 4 et permet ainsi d'éviter de rechercher la zone de détection de la touche sensitive 4.

En outre, le positionnement de la source lumineuse 13 en vis-à-vis d'un premier élément de diffusion 14 guide de lumière 7 permet d'éviter de visualiser un point lumineux au travers de la plaque électriquement isolante 2. Le premier élément de diffusion 14 diffuse la lumière de la source lumineuse 13 montée sur la plaquette de circuit imprimé 3 dans le guide de lumière 7.

La surface inférieure 6 du second élément de diffusion 15 du guide de lumière 7 est posée sur la face de détection 5 de la touche sensitive 4.

Ainsi, le guide de lumière 7 est supporté par la touche sensitive 4 et repoussé par la partie intermédiaire élastique 8 de ladite touche sensitive 4.

La surface inférieure 6 du guide de lumière 7 réfléchit la lumière en direction de la plaque électriquement isolante 2.

Ainsi, la lumière est diffusée en direction de ladite au moins une partie transparente ou translucide de la plaque électriquement isolante 2 afin de signaler l'état de fonctionnement de la touche sensitive 4. Ladite surface intérieure 6 réfléchissante permet d'obtenir une meilleure diffusion de la lumière en direction de la plaque électriquement isolante 2 et d'améliorer l'intensité du faisceau lumineux traversant ladite au moins une partie transparente ou translucide de la plaque électriquement isolante 2.

Le guide de lumière 7 comporte deux premiers éléments de diffusion de lumière 14 s'étendant entre la plaquette de circuit imprimé 3 et la plaque électriquement isolante 2.

Lesdits deux premiers éléments de diffusion de lumière 14 sont reliés respectivement à une extrémité du second élément de diffusion 15 du guide de lumière 7.

Et lesdits deux premiers éléments de diffusion de lumière 14 sont positionnés respectivement en vis-à-vis d'une source lumineuse 13.

Ainsi, la lumière est diffusée au travers de deux premiers éléments de diffusion 14 reliés respectivement à un deuxième élément de diffusion 15 du guide de lumière 7 afin d'afficher l'icône représenté sur la plaque électriquement isolante 2. La lumière diffusée par les deux sources lumineuses 13 au travers des éléments de diffusion 14 et 15 du guide de lumière 7 est uniforme. Un tel agencement des éléments de diffusion du guide de lumière dans le dispositif à touche sensitive 1 permet d'éviter des déperditions de lumière et de garantir un niveau de luminosité déterminé par l'intensité des sources lumineuses 13.

Les deux premiers éléments de diffusion 14 permettent d'illuminer le dispositif à touche sensitive 1 de chaque côté de la touche sensitive 4 et d'homogénéiser le faisceau lumineux dans le second élément de diffusion 15 du guide de lumière 7.

Le guide de lumière 7 est constitué par deux premiers éléments de diffusion 14 et un second élément de diffusion 15 de sorte à former un U à l'envers.

Une surface extérieure 16 d'une zone de connexion 17 entre ledit au moins un premier élément de diffusion 14 de lumière et le second élément de diffusion 15 de lumière du guide de lumière 7 est inclinée d'un angle α.

Préférentiellement, l'angle α d'inclinaison de la surface extérieure 16 d'une zone de connexion 17 entre ledit au moins un premier élément de diffusion de lumière 14 et le second élément de diffusion de lumière 15 du guide de lumière 7 est de l'ordre de 45°.

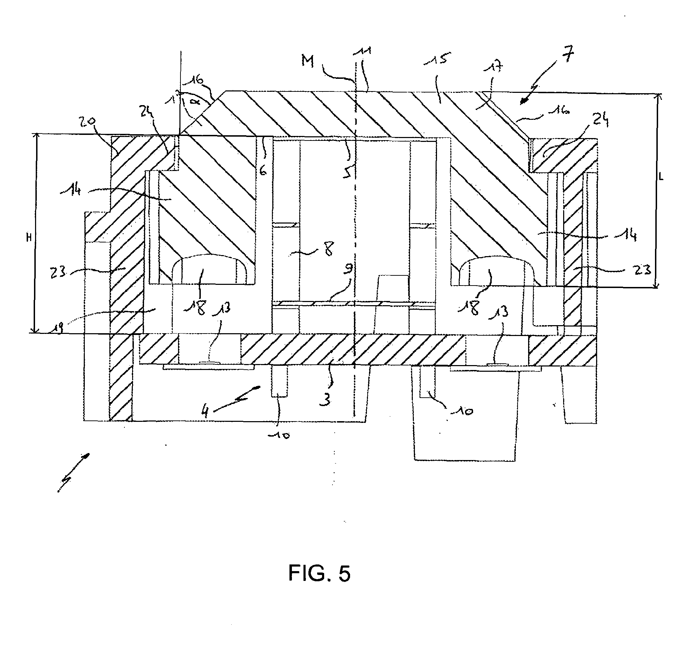

L'orientation angulaire α, illustrée à la figure 5, de la surface extérieure 16 de la zone de connexion 17 permet de réfléchir la lumière provenant d'un premier élément de diffusion 14 vers le second élément de diffusion 15 du guide de lumière 7. Avec une telle inclinaison α, l'intensité lumineuse diffusée par le guide de lumière 7 dans la plaque électriquement isolante 7 est améliorée.

Pour diminuer les pertes de diffusion de lumière dans le guide de lumière, les surfaces du guide de lumière 7 sont recouvertes d'un revêtement diffusant la lumière à l'intérieur dudit guide de lumière 7 hormis la surface inférieure réfléchissante 6 et la surface pleine de diffusion de la lumière 11 dudit guide de lumière 7.

Lesdites surfaces du guide de lumière 7 sont recouvertes d'un papier adhésif en aluminium de sorte à réfléchir la lumière de la source lumineuse 13 vers l'intérieur du guide de lumière 7. De cette manière, les faisceaux lumineux de la source lumineuse rebondissent sur les surfaces du guide de lumière recouvertes d'un revêtement diffusant la lumière.

Ensuite ces faisceaux lumineux sont réfléchis par la surface extérieure 16 inclinée de la zone de connexion 17 en direction de la surface inférieure réfléchissante 6 du second élément de diffusion 15 du guide de lumière 7.

La surface inférieure 6 du second élément de diffusion 15 du guide de lumière 7 peut être recouverte d'un film ayant une rugosité spécifique permettant de réfléchir les faisceaux lumineux à la verticale en direction de la surface inférieure 11 de la plaque électriquement isolante 2.

Ledit film recouvrant la surface inférieure 6 du second élément de diffusion 15 du guide de lumière 7 peut être de couleur blanc.

Avantageusement, ledit au moins un premier élément de diffusion 14 du guide de lumière 7 comprend un évidement 18 en vis-à-vis de ladite au moins une source lumineuse 13.

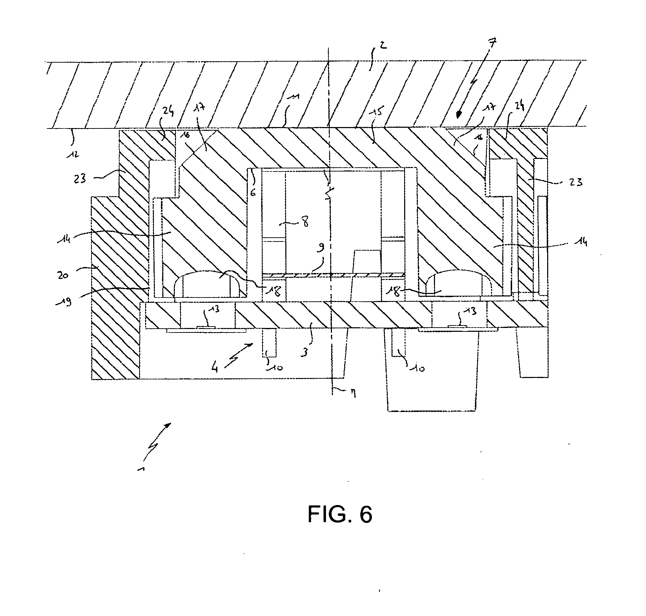

L'évidemment 18 permet de diffuser la lumière à l'intérieur du premier élément de diffusion du guide de lumière 7. La forme de l'évidemment 18 est préférentiellement de forme sphérique. En particulier dans le mode de réalisation illustré aux figures 5 et 6, le rayon de l'évidemment 18 est de l'ordre de 4mm.

L'évidemment 18 permet de diffuser la lumière dans la totalité de l'épaisseur du premier élément de diffusion 14 du guide de lumière 7 de sorte à éviter un faisceau principal de forte intensité et des zones peu illuminées du guide de lumière 7.

Au moins deux sources lumineuses 13 sont placées de part et d'autre d'un plan médian M de la touche sensitive 4.

Lesdites au moins deux sources lumineuses 13 sont placées symétriquement par rapport à un plan médian M traversant la touche sensitive 4 par sa hauteur. La lumière est répartie uniformément à l'intérieur du guide de lumière 7 du dispositif à touche sensitive 1.

De préférence, lesdites au moins deux sources lumineuses 13 sont placées à égale distance du plan médian M traversant verticalement la touche sensitive 4.

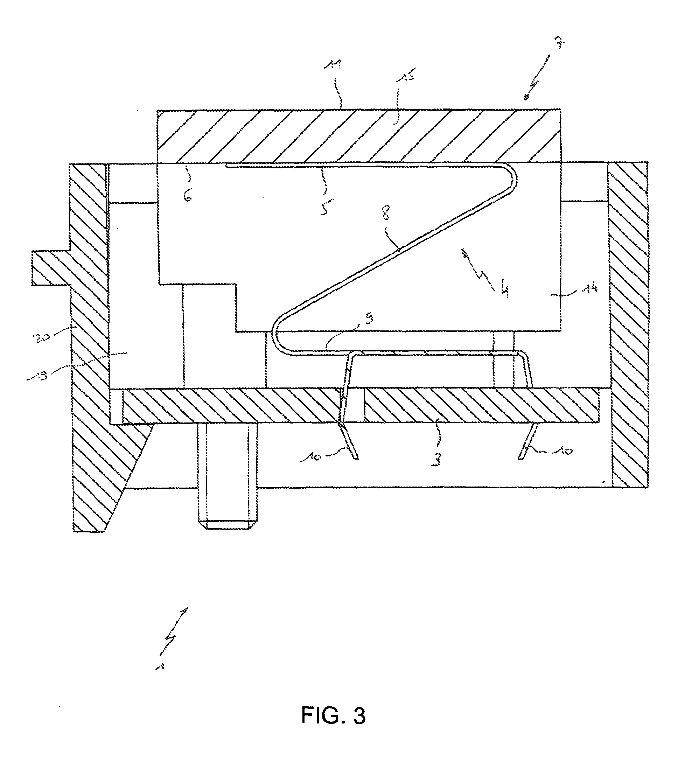

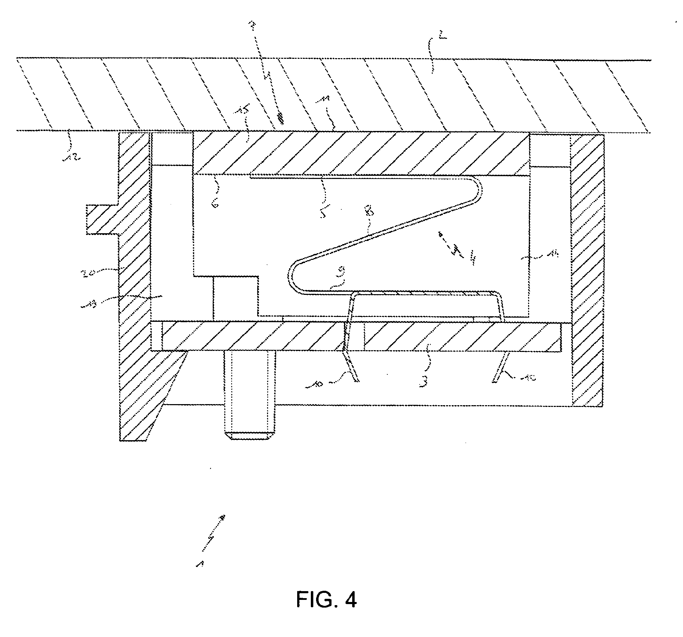

La touche sensitive 4 prend deux positions, une première position, illustrée aux figures 3 et 5, où la partie intermédiaire élastique 8 est non comprimée par la plaque électriquement isolante 2, et une seconde position, illustrée aux figures 4 et 6, où le guide de lumière 7 est en contact avec la plaque électriquement isolante 2 de sorte à comprimer ladite partie intermédiaire élastique 8 de la touche sensitive 4.

Dans un mode de réalisation de l'invention illustré à la figure 5, la longueur L dudit au moins un premier élément de diffusion 14 du guide de lumière 7 est inférieure à la distance H séparant la plaquette de circuit imprimé 3 de la face de détection 5 de la touche sensitive 4 lorsque la partie intermédiaire élastique 8 de ladite touche sensitive est au repos.

De cette manière, le guide de lumière 7 a un débattement dépendant de la touche sensitive 4 permettant d'assurer la mise en appui de la totalité de la surface de diffusion de la lumière 11 lorsque la plaque électriquement isolante 2 est en appui sur le guide de lumière 7, et d'éviter que ledit au moins un premier élément de diffusion 14 exerce une contrainte sur la plaquette de circuit imprimé 3.

La touche sensitive 4 et le guide de lumière 7 sont placés à l'intérieur d'un logement 19 d'un boîtier 20

Le boîtier 20 s'étend de la plaquette de circuit imprimé 3 à la surface inférieure 12 de la plaque électriquement isolante 2.

Ainsi, la lumière diffusée par le guide de lumière 7 est canalisée à l'intérieur d'un logement 19 d'un boîtier 20 pour un dispositif à touche sensitive 1 sans éclairer un autre dispositif à touche sensitive 1 pouvant être situé à proximité ou sans laisser un passage de lumière en direction d'une partie transparente ou translucide de la plaque électrique isolante 2 n'appartenant pas audit dispositif 1.

Le boîtier 20 permet de délimiter la zone de la touche sensitive 4 en la séparant par des parois verticales de l'environnement autour dudit boîtier 20.

Le boîtier 20 de la touche sensitive 4 comprend quatre parois et préférentiellement de couleur noire pour absorber la luminosité pouvant être émise par les deux sources lumineuses 13.

La couleur noire du boîtier 20 permet également lors de l'extinction des deux sources lumineuses 13 de ne voir aucun élément au travers de la plaque électriquement isolante 2.

Le faisceau de lumière des sources lumineuses 13 ne peut être diffusée à l'extérieur du boîtier 20. La zone d'appui d'une touche sensitive 4 est délimitée par une séparation physique formée de parois verticales. La zone d'appui d'une touche sensitive 4 est associée à une fonction de commande d'un appareil électrique.

En pratique, ledit au moins un premier élément de diffusion 14 du guide de lumière 7 comprend une nervure 21 coulissant à l'intérieur d'une rainure 22 formée sur une paroi 23 du logement 19 du boîtier 20.

Ainsi, le guide de lumière 7 est positionné à l'intérieur du logement 19 du boîtier 20 et le déplacement de celui-ci est maîtrisé. La partie intermédiaire élastique 8 de la touche sensitive 4 permet ainsi de déplacer le guide de lumière 7 à l'intérieur du logement 19 du boîtier 20 selon une direction prédéterminée. Le déplacement du guide de lumière 7 est guidé et permet d'assurer que le contact entre le guide de lumière 7 et la plaque électriquement isolante 2 est réalisé sur la totalité de la surface pleine de diffusion de lumière 11 du guide de lumière 7.

Le déplacement du guide de lumière 7 sous l'effet de la partie intermédiaire élastique 8 de la touche sensitive 4 de la plaquette de circuit imprimé 3 vers l'extérieur du boîtier 20 est limité par au moins une butée 24 du logement 19 du boîtier 20.

Ainsi, le guide de lumière 7 ne peut sortir du logement 19 du boîtier 20 tant que la plaque électriquement isolante 2 ne comprime pas la touche sensitive 4 par l'intermédiaire du guide de lumière 7. Le guide de lumière 7 est poussé d'une part par la partie intermédiaire élastique 8 de la touche sensitive 4 et d'autre part maintenu par la butée 24 du logement 19 du boîtier 20. Le guide de lumière est ainsi emprisonné entre le boîtier 20 et la touche sensitive 4 lors de l'assemblage du dispositif à touche sensitive 1 et facilite ainsi cet assemblage.

Le dispositif à touche sensitive 1 peut ainsi être préparé avant l'assemblage sur un appareil électrique domestique. Ce dispositif à touche sensitive 1 peut être assemblé sur un bandeau de commande suivant une direction quelconque et appropriée à chaque type d'appareil électrique domestique, pouvant être verticale, horizontale ou inclinée.

Le guide de lumière 7 de la touche sensitive 4 est repoussé par la face de détection 5 de la touche sensitive 4 vers la butée 24 du logement 19. Ainsi, le guide de lumière 7 est maintenu à l'intérieur du logement 19 du boîtier 20 tout en laissant une liberté de mouvement suivant le rail de guidage formé dans ledit logement 19 par la nervure 21 et la rainure 22.

Le blocage du guide de lumière 7 dans le logement 19 est assuré par la nervure 21 du guide de lumière prenant appui sur la butée 24 ménagée sur la paroi 23 du logement 19.

Dans un mode de réalisation de l'invention, une sérigraphie de la plaque électriquement isolante 2 peut être réalisée sur au moins une partie de la zone définie par le boîtier 20 enfermant la touche sensitive 4.

Au moins une partie transparente ou translucide de la plaque électriquement isolante 2 peut être réalisée au-dessus ou autour de la face de détection 5 opaque de ladite touche sensitive 4 pour permettre le passage de la lumière émise par lesdites au moins deux sources lumineuses 10.

Préférentiellement, les sources lumineuses 13 se situent au droit de ladite sérigraphie et en dehors de ladite au moins une partie transparente ou translucide de la plaque électriquement isolante 2.

En effet, ceci évite un éclairage direct par les sources lumineuses 13 et donc une hétérogénéité de la lumière apparente.

La diffusion de lumière des deux sources lumineuses 13 au travers du guide de lumière 7 puis de ladite au moins une partie transparente ou translucide de la plaque électriquement isolante 2 permet d'identifier une zone d'appui, une touche sensitive activée et les touches actives d'une interface avec un utilisateur.

Un élément d'identification de la touche sensitive 4 peut être réalisé par sérigraphie à l'intérieur de la forme de ladite au moins une partie transparente ou translucide de la plaque électriquement isolante 2.

De cette manière, la fonction de la touche sensitive 4 est associée à cet élément d'identification. Cet élément d'identification n'est pas rétro éclairé par les sources lumineuses 13.

Inversement, l'icône peut être réalisé en épargnant une sérigraphie déposée sur la plaque électriquement isolante 2.

L'élément d'identification est situé au-dessus de la face de détection 5 de la touche sensitive 4.

Lorsque le dispositif à touche sensitive 1 n'est pas éclairé, ladite au moins une partie transparente ou translucide de la plaque électriquement isolante 2 et la sérigraphie de l'élément d'identification apparaissent de manière à déterminer l'emplacement de ladite touche sensitive 4.

Ladite au moins une partie transparente ou translucide de la plaque électriquement isolante 2 peut comprendre au moins un dépoli pour favoriser la diffusion de lumière au travers de ladite plaque électriquement isolante 2.

Les sources lumineuses 13 peuvent être des diodes électroluminescentes.

Les deux sources lumineuses 13 sont montées à l'intérieur de la plaquette de circuit imprimé 3 selon un procédé de fabrication de type composants montés en surface (CMS).

Ce mode de fabrication de la plaquette de circuit imprimé 3 permet de réduire le coût d'obtention de celle-ci.

Les sources lumineuses 13 sont placées à proximité de l'embase 9 de la touche sensitive 4. La distance entre une source lumineuse 13 et l'embase 9 de la touche sensitive 4 est comprise dans une plage s'étendant entre 1mm et 5mm, et préférentiellement de l'ordre de 2mm.

Les sources lumineuses 13 sont situées en dessous de la surface de la plaquette de circuit imprimé 3 comprenant la touche sensitive 4.

Le dispositif à touche sensitive 1 peut être intégré dans tout type de clavier de commande pour un appareil électrique domestique.

En pratique, un clavier de commande comporte plusieurs dispositifs à touche sensitive, et plus particulièrement plusieurs touches sensitives enfermées dans des boîtiers respectifs, les touches sensitives 4 pouvant toutes être montées sur une même plaquette de circuit imprimé 3.

On notera que dans ce cas, les boîtiers peuvent être réalisés par une pièce unique en matière plastique. Un afficheur peut éventuellement être placé à l'intérieur de la pièce unique formant les boîtiers des touches sensitives.

Le dispositif à touche sensitive 1 permet une personnalisation des appareils électriques domestiques en modifiant uniquement les icônes représentés sur la plaque électriquement isolante 2. Une plaquette de circuit imprimé 3 identique reliée à plusieurs touches sensitives 4, selon l'invention, peut être utilisée pour différents types d'appareils électriques domestiques. Ainsi, cet ensemble permet de réduire les coûts d'obtention d'un clavier de commande comprenant une pluralité de dispositifs à touches sensitives.

## Revendications

1. Dispositif à touche sensitive (1) par effet capacitif pour détecter la présence d'un élément à travers une plaque électriquement isolante (2), la touche sensitive (4) comportant une face de détection (5) pleine destinée à être plaquée contre une surface inférieure (6) d'un guide de lumière (7), ladite face de détection (5) de ladite touche sensitive (4) étant opaque à la lumière, et ladite touche sensitive (4) étant portée par une plaquette de circuit imprimé (3), le guide de lumière (7) comportant une surface pleine de diffusion de la lumière (11) destinée à être plaquée contre une surface intérieure (12) de la plaque électriquement isolante (2), **caractérisé en ce que** le dispositif à touche sensitive (1) comprend :
- au moins une source lumineuse (13) assemblée sur la plaquette de circuit imprimé (3) et placée en vis-à-vis d'au moins un premier élément de diffusion (14) du guide de lumière (7) ;
- ledit au moins un premier élément de diffusion (14) du guide de lumière (7) étant relié à un second élément de diffusion (15) du guide de lumière (7) ;
- ledit second élément de diffusion (15) du guide de lumière (7) comprenant la surface inférieure (6) et la surface pleine de diffusion de la lumière (11) dudit guide de lumière (7) ;
- ledit second élément de diffusion (15) du guide de lumière (7) étant positionné entre la face de détection (5) de la touche sensitive (4) et la surface inférieure (12) de la plaque électriquement isolante (2) ;
- ladite surface pleine de diffusion de la lumière (11) étant plaquée contre la surface intérieure (12) de la plaque électriquement isolante (2) par une partie intermédiaire élastique (8) de la touche sensitive (4) ;
- au moins une partie transparente ou translucide de la plaque électriquement isolante (2) étant réalisée en vis-à-vis de la face de détection opaque (5) de ladite touche sensitive (4) pour permettre le passage de la lumière émise par ladite au moins une source lumineuse (13) et diffusée au travers du guide de lumière (7) ;
- au moins un icône représenté sur la plaque électriquement isolante (2) étant réalisé sur au moins une partie de la zone définie par la projection de la face de détection (5) opaque de ladite touche sensitive (4) sur ladite plaque électriquement isolante (2) ; et
- la surface pleine de diffusion de la lumière (11) du guide de lumière (7) recouvrant au moins la surface dudit au moins un icône représenté sur la plaque électriquement isolante (2).

2. Dispositif à touche sensitive selon la revendication 1, **caractérisé en ce que** la surface inférieure (6) du guide de lumière (7) réfléchit la lumière en direction de la plaque électriquement isolante (2).

3. Dispositif à touche sensitive selon la revendication 1 ou 2, **caractérisé en ce que** le guide de lumière (7) comporte deux premiers éléments de diffusion (14) de lumière s'étendant entre la plaquette de circuit imprimé (3) et la plaque électriquement isolante (2), lesdits deux premiers éléments de diffusion de lumière (14) étant reliés respectivement à une extrémité du second élément de diffusion (15) du guide de lumière (7), et lesdits deux premiers éléments de diffusion de lumière (14) étant positionnés respectivement en vis-à-vis d'une source lumineuse (13).

4. Dispositif à touche sensitive selon l'une quelconque des revendications 1 à 3, **caractérisé en ce que** la longueur (L) dudit au moins un premier élément de diffusion (14) du guide de lumière (7) est inférieure à la distance (H) séparant la plaquette de circuit imprimé (3) de la face de détection (5) de la touche sensitive (4) lorsque la partie intermédiaire élastique (8) de ladite touche sensitive (4) est au repos.

5. Dispositif à touche sensitive selon l'une quelconque des revendications 1 à 4, **caractérisé en ce que** ledit au moins un premier élément de diffusion (14) du guide de lumière (7) comprend un évidement (18) en vis-à-vis de ladite au moins une source lumineuse (13).

6. Dispositif à touche sensitive selon l'une quelconque des revendications 1 à 5, **caractérisé en ce qu'**une surface extérieure (16) d'une zone de connexion (17) entre ledit au moins un premier élément de diffusion de lumière (14) et le second élément de diffusion de lumière (15) du guide de lumière (7) est inclinée d'un angle (α).

7. Dispositif à touche sensitive selon l'une quelconque des revendications 1 à 6, **caractérisé en ce que** la touche sensitive (4) et le guide de lumière (7) sont placés à l'intérieur d'un logement (19) d'un boîtier (20), ledit boîtier (20) s'étendant de la plaquette de circuit imprimé (3) à la surface inférieure (12) de la plaque électriquement isolante (2).

8. Dispositif à touche sensitive selon la revendication 7, **caractérisé en ce que** ledit au moins un premier élément de diffusion (14) du guide de lumière (7) comprend une nervure (21) coulissant à l'intérieur d'une rainure (22) formée sur une paroi (23) du logement (19) du boîtier (20).

9. Dispositif à touche sensitive selon la revendication 7 ou 8, **caractérisé en ce que** le déplacement du guide de lumière (7) sous l'effet de la partie intermédiaire élastique (8) de la touche sensitive (4) de la plaquette de circuit imprimé (3) vers l'extérieur du boîtier (20) est limité par au moins une butée (24) du logement (19) du boîtier (20).

10. Dispositif à touche sensitive selon l'une quelconque des revendications 1 à 9, **caractérisé en ce qu'**au moins deux sources lumineuses (13) sont placées de part et d'autre d'un plan médian (M) de la touche sensitive (4).

11. Dispositif à touche sensitive selon l'une quelconque des revendications 2 à 10, **caractérisé en ce que** les surfaces du guide de lumière (7) sont recouvertes d'un revêtement diffusant la lumière à l'intérieur dudit guide de lumière (7) hormis la surface inférieure réfléchissante (6) et la surface pleine de diffusion de la lumière (11) dudit guide de lumière (7).

12. Dispositif à touche sensitive selon l'une quelconque des revendications 1 à 11, **caractérisé en ce que** la touche sensitive (4) prend deux positions, une première position où la partie intermédiaire élastique (8) est non comprimée par la plaque électriquement isolante (2), et une seconde position où le guide de lumière (7) est en contact avec la plaque électriquement isolante (2) de sorte à comprimer ladite partie intermédiaire élastique (8) de la touche sensitive (4).

13. Dispositif à touche sensitive selon l'une quelconque des revendications 1 à 12, **caractérisé en ce que** la touche sensitive (4) par effet capacitif est constituée par une lame ressort en forme de Z.

14. Dispositif à touche sensitive selon l'une quelconque des revendications 1 à 13, **caractérisé en ce que** le guide de lumière (7) est constitué par deux premiers éléments de diffusion (14) et un second élément de diffusion (15) de sorte à former un U à l'envers.

15. Clavier de commande, notamment pour appareils électriques domestiques,
**caractérisé en ce qu'**il comprend au moins un dispositif à touche sensitive conforme à l'une quelconque des revendications 1 à 14.

16. Appareil électrique domestique, **caractérisé en ce qu'**il comprend au moins un
dispositif à touche sensitive conforme à l'une quelconque des revendications 1 à 14 et/ou un clavier de commande conforme à la revendication 15.

## Claims

1. Touch-sensitive control device (1) with capacitive effect for detecting the presence of an element through an electrically insulating plate (2), the touch-sensitive control (4) comprising a full detection face (5) intended to be pinned against a lower surface (6) of an optical waveguide (7), said detection face (5) of said touch-sensitive control (4) being opaque to light, and said touch-sensitive control (4) being carried by a printed circuit wafer (3), the optical waveguide (7) comprising a full light diffusion surface (11) intended to be pinned against a lower surface (12) of the electrically insulating plate (2), **characterized in that** the touch-sensitive control device (1) includes:
- at least one light source (13) assembled on the printed circuit wafer (3) and placed opposite at least one first diffusion element (14) of the optical waveguide (7);
- said at least one first diffusion element (14) of the optical waveguide (7) being connected to a second diffusion element (15) of the optical waveguide (7);
- said second diffusion element (15) of the optical waveguide (7) including the lower surface (6) and the full light diffusion surface (11) of said optical waveguide (7);
- said second diffusion element (15) of the optical waveguide (7) being positioned between the detection face (5) of the touch-sensitive control (4) and the lower surface (12) of the electrically insulating plate (2);
- said full light diffusion surface (11) being pinned against the lower surface (12) of the electrically insulating plate (2) through an intermediate elastic part (8) of the touch-sensitive control (4);
- at least one transparent or translucent part of the electrically insulating plate (2) being placed opposite the opaque detection face (5) of said touch-sensitive control (4) to allow the passing of the light emitted by said at least one light source (13) and diffused through the optical waveguide (7);
- at least one icon represented on the electrically insulating plate (2) being placed on at least one part of the zone defined by the projection of the opaque detection face (5) of said touch-sensitive control (4) on said electrically insulating plate (2); and
- the full light diffusion surface (11) of the optical waveguide (7) covering at least the surface of said at least one icon represented on the electrically insulating plate (2).

2. Touch-sensitive control device according to claim 1, **characterized in that** the lower surface (6) of the optical waveguide (7) reflects the light in the direction of the electrically insulating plate (2).

3. Touch-sensitive control device according to claim 1 or 2, **characterized in that** the optical waveguide (7) includes two first light diffusion elements (14) extending between the printed circuit wafer (3) and the electrically insulating plate (2), said two first light diffusion elements (14) being connected respectively to one end of the second diffusion element (15) of the optical waveguide (7), and said two first light diffusion elements (14) being positioned respectively opposite a light source (13).

4. Touch-sensitive control device according to any of claims 1 to 3, **characterized in that** the length (L) of said at least one first diffusion element (14) of the optical waveguide (7) is less than the distance (H) separating the printed circuit wafer (3) from the detection face (5) of the touch-sensitive control (4) when the intermediate elastic part (8) of said touch-sensitive control (4) is idle.

5. Touch-sensitive control device according to any of claims 1 to 4, **characterized in that** said at least one first diffusion element (14) of the optical waveguide (7) includes a recess (18) opposite said at least one light source (13).

6. Touch-sensitive control device according to any of claims 1 to 5, **characterized in that** an external surface (16) of a connection zone (17) between said at least one first light diffusion element (14) and the second light diffusion element (15) of the optical waveguide (7) is at an angle (α).

7. Touch-sensitive control device according to any of claims 1 to 6, **characterized in that** the touch-sensitive control (4) and the optical waveguide (7) are placed inside a housing (19) of an enclosure (20), said enclosure (20) extending from the printed circuit wafer (3) to the lower surface (12) of the electrically insulating plate (2).

8. Touch-sensitive control device according to claim 7, **characterized in that** said at least one first diffusion element (14) of the optical waveguide (7) includes a rib (21) sliding inside a slot (22) formed by a wall (23) of the housing (19) of the enclosure (20).

9. Touch-sensitive control device according to claim 7 or 8, **characterized in that** the movement of the optical waveguide (7) under the effect of the intermediate elastic part (8) of the touch-sensitive control (4) of the printed circuit wafer (3) to outside the enclosure (20) is restricted by at least one stop (24) of the housing (19) of the enclosure (20).

10. Touch-sensitive control device according to any of claims 1 to 9, **characterized in that** at least two light sources (13) are placed either side of a median plane (M) of the touch-sensitive control (4).

11. Touch-sensitive control device according to any of claims 2 to 10, **characterized in that** the surfaces of the optical waveguide (7) are covered with a coating diffusing the light inside said optical waveguide (7) except for the reflective lower surface (6) and the full light diffusion surface (11) of said optical waveguide (7).

12. Touch-sensitive control device according to any of claims 1 to 11, **characterized in that** the touch-sensitive control (4) takes two positions, a first position in which the intermediate elastic part (8) is not compressed by the electrically insulating plate (2), and a second position in which the optical waveguide (7) is in contact with the electrically insulating plate (2) so as to compress said intermediate elastic part (8) of the touch-sensitive control (4).

13. Touch-sensitive control device according to any of claims 1 to 12, **characterized in that** the touch-sensitive control (4) with capacitive effect consists of a spring blade in the form of a Z.

14. Touch-sensitive control device according to any of claims 1 to 13, **characterized in that** the optical waveguide (7) consists of two first diffusion elements (14) and a second diffusion element (15) so as to form an upside-down U shape.

15. Control keypad, in particular for domestic electrical appliances, **characterized in that** it includes at least one touch-sensitive control device in accordance with any of claims 1 to 14.

16. Domestic electrical appliance, **characterized in that** it includes at least one touch-sensitive control device in accordance with any of claims 1 to 14 and/or a control keypad in accordance with claim 15.

## Patentansprüche

1. Vorrichtung mit kapazitiver Sensortaste (1) zum Nachweis des Vorhandenseins eines Elements durch eine elektrisch isolierende Platte (2), wobei die Sensortaste (4) eine Sensor-Vollfläche (5) umfasst, welche dazu bestimmt ist, gegen eine untere Fläche (6) eines Lichtleiters (7) gepresst zu werden, wobei die besagte Sensorfläche (5) der besagten Sensortaste (4) lichtundurchlässig ist, wobei die besagte Sensortaste (4) von einer gedruckten Leiterplatte (3) getragen wird, und wobei der Lichtleiter (7) eine lichtstreuende Vollfläche (11) umfasst, welche dazu bestimmt ist, gegen eine Innenfläche (12) der elektrisch isolierenden Platte (2) gepresst zu werden, **dadurch gekennzeichnet, dass** die Vorrichtung mit Sensortaste (1) umfasst:
- Mindestens eine Lichtquelle (13), welche auf der gedruckten Leiterplatte (3) montiert und gegenüberliegend zu mindestens einem ersten Diffusorelement (14) des Lichtleiters (7) angeordnet ist;
- wobei das besagte mindestens eine erste Diffusorelement (14) des Lichtleiters (7) mit einem zweiten Diffusorelement (15) des Lichtleiters (7) verbunden ist;
- wobei das besagte zweite Diffusorelement (15) des Lichtleiters (7) die untere Fläche (6) und die lichtstreuende Vollfläche (11) des besagten Lichtleiters (7) umfasst;
- wobei das besagte zweite Diffusorelement (15) des Lichtleiters (7) zwischen der Sensorfläche (5) der Sensortaste (4) und der unteren Fläche (12) der elektrisch isolierenden Platte (2) angeordnet ist;
- wobei die besagte lichtstreuende Vollfläche (11) mittels eines federnden Zwischenabschnitts (8) der Sensortaste (4) gegen die Innenfläche (12) der elektrisch isolierenden Platte (2) gepresst wird;
- wobei sich mindestens ein transparenter oder lichtdurchlässiger Abschnitt der elektrisch isolierenden Platte (2) gegenüber der lichtundurchlässigen Sensorfläche (5) der besagten Sensortaste (4) befindet, um das von der mindestens einen Lichtquelle (13) erzeugte und über den Lichtleiter (7) gestrahlte Licht durchzulassen;
- wobei mindestens ein auf der elektrisch isolierenden Platte (2) dargestelltes Icon auf mindestens einem Abschnitt der von der Projektion der lichtundurchlässigen Sensorfläche (5) der besagten Sensortaste (4) auf die besagte elektrisch isolierende Platte (2) definierten Zone ausgeführt ist; und
- wobei die lichtstreuende Vollfläche (11) des Lichtleiters (7) mindestens die Fläche des besagten auf der elektrisch isolierenden Platte (2) dargestellten mindestens en Icons abdeckt.

2. Vorrichtung mit Sensortaste nach Anspruch 1, **dadurch gekennzeichnet, dass** die untere Fläche (6) des Lichtleiters (7) das Licht in Richtung der elektrisch isolierenden Platte (2) reflektiert.

3. Vorrichtung mit Sensortaste nach Anspruch 1 oder 2, **dadurch gekennzeichnet, dass** der Lichtleiter (7) zwei erste Lichtdiffusorelemente (14) umfasst, welche sich zwischen der gedruckten Leiterplatte (3) und der elektrisch isolierenden Platte (2) erstrecken, wobei die besagten zwei ersten Lichtdiffusorelemente (14) jeweils mit einem Ende des zweiten Diffusorelements (15) des Lichtleiters (7) verbunden sind, und wobei die besagten zwei ersten Lichtdiffusorelemente (14) jeweils gegenüberliegend zu einer Lichtquelle (13) angeordnet sind.

4. Vorrichtung mit Sensortaste nach einem beliebigen der Ansprüche 1 bis 3, **dadurch gekennzeichnet, dass** die Länge (L) des besagten mindestens einen ersten Diffusorelements (14) des Lichtleiters (7) kleiner ist als der Abstand (H) zwischen der gedruckten Leiterplatte (3) und der Sensorfläche (5) der Sensortaste (4), wenn sich der federnde Zwischenabschnitt (8) der besagten Sensortaste (4) in Ruhestellung befindet.

5. Vorrichtung mit Sensortaste nach einem beliebigen der Ansprüche 1 bis 4, **dadurch gekennzeichnet, dass** das besagte mindestens eine erste Diffusorelement (14) des Lichtleiters (7) eine Aussparung (18) gegenüber der besagten mindestens einen Lichtquelle (13) aufweist.

6. Vorrichtung mit Sensortaste nach einem beliebigen der Ansprüche 1 bis 5, **dadurch gekennzeichnet, dass** eine Außenfläche (16) einer Verbindungszone (17) zwischen dem besagten mindestens einen ersten Lichtdiffusorelement (14) und dem zweiten Lichtdiffusorelement (15) des Lichtleiters (7) um einen Winkel (α) geneigt ist.

7. Vorrichtung mit Sensortaste nach einem beliebigen der Ansprüche 1 bis 6, **dadurch gekennzeichnet, dass** die Sensortaste (4) und der Lichtleiter (7) im Inneren einer Aussparung (19) eines Gehäuses (20) angeordnet sind, wobei sich das besagte Gehäuse (20) von der gedruckten Leiterplatte (3) bis zur unteren Fläche (12) der elektrisch isolierenden Platte (2) erstreckt.

8. Vorrichtung mit Sensortaste nach Anspruch 7, **dadurch gekennzeichnet, dass** das besagte mindestens eine erste Diffusorelement (14) des Lichtleiters (7) eine Rippe (21) umfasst, welche im Inneren einer auf einer Wand (23) der Aussparung (19) des Gehäuses (20) gebildeten Nut (22) gleitet.

9. Vorrichtung mit Sensortaste nach Anspruch 7 oder 8, **dadurch gekennzeichnet, dass** die Bewegung des Lichtleiters (7) unter der Einwirkung des federnden Zwischenabschnitts (8) der Sensortaste (4) von der gedruckten Leiterplatte (3) zum Äußeren des Gehäuses (20) durch mindestens einen Anschlag (24) der Aussparung (19) des Gehäuses (20) begrenzt wird.

10. Vorrichtung mit Sensortaste nach einem beliebigen der Ansprüche 1 bis 9, **dadurch gekennzeichnet, dass** mindestens zwei Lichtquellen (13) beiderseits einer Mittelebene (M) der Sensortaste (4) angeordnet sind.

11. Vorrichtung mit Sensortaste nach einem beliebigen der Ansprüche 2 bis 10, **dadurch gekennzeichnet, dass** die Flächen des Lichtleiters (7) mit einer Beschichtung versehen sind, welche das Licht im Inneren des besagten Lichtleiters (7) streut, mit Ausnahme der unteren reflektierenden Fläche (6) und der lichtstreuenden Vollfläche (11) des besagten Lichtleiters (7).

12. Vorrichtung mit Sensortaste nach einem beliebigen der Ansprüche 1 bis 11, **dadurch gekennzeichnet, dass** die Sensortaste (4) zwei Positionen einnimmt, eine erste Position, in welcher der federnde Zwischenabschnitt (8) nicht von der elektrisch isolierenden Platte (2) komprimiert wird, und eine zweite Position, in welcher der Lichtleiter (7) mit der elektrisch isolierenden Platte (2) in Kontakt steht, so dass der besagte federnde Zwischenabschnitt (8) der Sensortaste (4) komprimiert wird.

13. Vorrichtung mit Sensortaste nach einem beliebigen der Ansprüche 1 bis 12, **dadurch gekennzeichnet, dass** die kapazitive Sensortaste (4) aus einer Blattfeder in Z-Form besteht.

14. Vorrichtung mit Sensortaste nach einem beliebigen der Ansprüche 1 bis 13, **dadurch gekennzeichnet, dass** der Lichtleiter (7) aus zwei ersten Diffusorelementen (14) und einem zweiten Diffusorelement (15) besteht, so dass die Form eines umgekehrten U gebildet wird.

15. Bedienungstastatur, insbesondere für elektrische Haushaltsgeräte, **dadurch gekennzeichnet, dass** es mindestens eine Vorrichtung mit Sensortaste gemäß einem beliebigen der Ansprüche 1 bis 14 umfasst.

16. Elektrisches Haushaltsgerät, **dadurch gekennzeichnet, dass** es mindestens eine Vorrichtung mit Sensortaste gemäß einem beliebigen der Ansprüche 1 bis 14 und/oder ein Bedienungstastatur gemäß Anspruch 15 umfasst.
